# EUROPEAN PATENT APPLICATION

(11) **EP 4 258 055 A1**
(43) Date of publication of application: **11.10.2023**
(21) Application number: 21900378.7
(22) Date of filing: 11.11.2021
(51) Int. Cl.: G03F 1/64, G03F 7/20

(54) **MEMBER FOR EXPOSURE DEVICE, MANUFACTURING METHOD FOR MEMBER FOR EXPOSURE DEVICE, AND COMPOSITE MEMBER FOR EXPOSURE DEVICE**

(30) Priority: 02.12.2020 JP 2020200596
(71) Applicant: Nisshinbo Chemical Inc., Tokyo 103-8650 (JP)
(72) Inventor: TOZAWA, Keisuke, Asahi-shi, Chiba 289-2505 (JP); MAYAMA, Kazuhiro, Asahi-shi, Chiba 289-2505 (JP)
(74) Representative: Steffan & Kiehne Patentanwälte PartG mbB
(86) International application number: PCT/JP2021/041438
(87) International publication number: WO 2022/118623

(57) **Abstract**

Provided is a member for exposure device, including glass-like carbon. Also, provided is a method for producing the member for exposure device, the method comprising: the step of forming a thermosetting resin material to prepare a resin formed body, and the step of carbonizing the resin formed body to obtain a glass-like carbon body. Also provided is a composite member for exposure device, including the member for exposure device.

## Description

### Technical Field

The present invention relates to a member for exposure device, a method for producing the member for exposure device, and a composite member for exposure device.

### Background Art

In the lithography step of patterning on a silicon wafer for a semiconductor device or the like, the patterning is carried out using exposure device. In the exposure device, a photomask, which is a base for exposure, is used and a circuit formed in the photomask is patterned on a silicon wafer. At that time, if foreign matters are adhered to the photomask or reticle, the pattern to be formed may result in a failure such as short circuit. Thus, for members for exposure device, which are members used in the exposure device, a material is selected from which a causative component of generation of dust or foreign matter does not fall. Also, a highly pure material is needed that has great resistance to exposure light and does not contaminate the silicon wafer itself.

Major examples of the member for exposure device include (a) a pellicle frame, which is generally a rectangular frame body and has an end surface serving as a pellicle film-setting surface, (b) a platy stage part for mounting a silicon wafer, (c) a disk-shaped mirror part for determination of a position, (d) a member for retaining an object to be exposed to light, such as a conveying arm having a U-shaped conveying part, and (e) other structural parts. A pellicle film is stretched and provided on the pellicle film-setting surface of the above-described pellicle frame to thereby form a pellicle, which performs the dust-proofing function for the photomask or reticle. Hereinafter, a silicon wafer may also be referred simply to as a "wafer."

As the pellicle frame, those made of aluminum or an aluminum alloy have been widely used heretofore, and pellicle frames made of another metal such as stainless steel, and pellicle frames made of a resin such as polyethylene have also been suggested (see, for example, PTLs 1 and 2).

For the above-described stage parts, mirror parts, and members for retaining an object to be exposed to light, such as a conveying arm, ceramic materials are used, which are generally easy to allow to have high purity and adaptable to complicate surface contours, and alumina and silicon carbide are widely used, for example. Furthermore, a complex material with ceramic having a negative thermal expansion characteristic has also been suggested (see, for example, PTL 3).

It is also known that a material having a small coefficient of linear expansion is used for the stage parts for the purpose of improving the accuracy of the position.

It is known that the mirror surface of the mirror parts is formed by vapor deposition of metal, and that less reflection is caused on moieties other than the mirror surface. It is known that in the members for retaining an object to be exposed to light, such as a conveying arm, the contact surface to be brought into contact with a wafer is tapered to reduce the influence on the wafer, for example.

In recent years, weight reduction of members for exposure device has been needed for the purpose of improving the moving speed of members for the drive system in the lithography step (exposure step) and enhancing ease of handling of members for the exposure device.

For example, aluminum, which is widely used for the material for pellicle frames, has a density of about 2.7 g/cm³, and making a pellicle frame of a material having a smaller density than aluminum is effective for the weight reduction of the members for exposure device. For example, a resin pellicle frame as described above is considered as a pellicle frame made of a material having a smaller density than aluminum.

However, since resins generally have a large coefficient of linear expansion, the resin pellicle frame thermally expands significantly when the temperature of the environment of the use increases. Usually, a light source for exposure is disposed such that the pellicle frame is not directly exposed in the patterning step; however, if stray light is generated due to exposure and hits the pellicle frame, the temperature of the pellicle frame increases.

If the resin pellicle frame thermally expands as described above, wrinkles, peeling, tearing, or the like may be formed in the pellicle film stretched and provided on the pellicle frame.

For the stage parts, the mirror parts, and the members for retaining an object to be exposed to light, such as a conveying arm, alumina (coefficient of linear expansion = 7.2×10⁻⁶/K, density = 3.9 g/cm³) or silicon carbide (coefficient of linear expansion = 3.7×10⁻⁶/K, density = 3.2 g/cm³) are usually used, which show small thermal expansion. Although these ceramics are materials having a smaller coefficient of linear expansion and a smaller density than those of metals, these ceramics may thermally expand to impair the accuracy of the exposure if the temperature of the member is increased by irradiation of the exposure light as described above. Therefore, a material having a much smaller coefficient of linear expansion and a much smaller density is needed for further improving ease of handling and the accuracy of the exposure. Also, a material having a smaller surface hardness than that of a wafer is expected in view of reducing adverse effects on the wafer.

### Citation List

### Patent Literature

PTL 1: JP 2009-025559A
PTL 2: JP 2018-028659A
PTL 3: JP 2006-009088A

### Summary of Invention

### Technical Problem

Recently, the wavelength of the exposure light for patterning has been shortened for the purpose of further improving the resolution of the exposed pattern, and for example, deep ultraviolet light (DUV) and light having a wavelength adjacent to 10 nm (EUV) are used. When a source of such high energy light is used, the temperature inside the exposure device raises remarkably, and it is surmised that temperatures of some parts may reach several hundred degrees Celsius. Particularly, in a case where such light having an ultra-short wavelength is radiated in an evacuated environment, there is concern about impurities and the like desorbed from parts used in the exposure device due to fluidity of gas, and it is thus considered that the influence of the temperature increase, including thermal expansion, is considerable.

As for pellicle frames as an example, wrinkles, peeling, tearing, or the like may be formed in the pellicle film stretched and provided on the pellicle frame due to thermal expansion, not only in a case where it is a resin pellicle frame described above but also in a case where it is an aluminum pellicle frame. For the stage parts, the mirror parts, and the members for retaining an object to be exposed to light, there is concern about deterioration in the accuracy of the position due to thermal expansion. Also, for any parts and members contacting with an object to be exposed to light, there is concern about the influence on the object to be exposed to light, and for parts and members facing to the space in which an object to be exposed to light is placed, there is concern about the influence of desorption of impurities and the like.

Accordingly, there is a need for a member for exposure device that is light and unlikely to thermally expand, which can also improve the moving speed of members for the drive system to enhance ease of handling, and is further unlikely to cause deformation even in patterning using a source of high energy light.

Taking the problems described above into account, an object of the present invention is to provide a member for exposure device that is light and unlikely to thermally expand, a method for producing the member for exposure device, and a composite member for exposure device.

### Solution to Problem

The present inventors have conducted diligent studies to solve the above-described problems, and as a result, have found that the problems may be solved by incorporating glass-like carbon into a member for exposure device, thus completing the present invention.

Specifically, the present invention provides [1] to [13] below.
[1] A member for exposure device, comprising glass-like carbon.
[2] The member for exposure device according to [1], wherein the glass-like carbon has a density of 1.6 g/cm³ or less.
[3] The member for exposure device according to [1] or [2], wherein the glass-like carbon has a Shore hardness (HS) of 100 or more.
[4] The member for exposure device according to any one of [1] to [3], wherein the glass-like carbon has a coefficient of linear expansion of 4.0×10⁻⁶/K or less.
[5] The member for exposure device according to any one of [1] to [4], wherein the glass-like carbon has an ash content of 50 ppm by mass or less.
[6] The member for exposure device according to any one of [1] to [5], wherein in a Raman spectrum of the glass-like carbon,
   a peak intensity ratio I_{D}/I_{G} is 1.0 to 2.5, wherein I_{D} represents a peak intensity of a D band within a range from 1300 to 1400 cm⁻¹, and I_{G} represents a peak intensity of a G band within a range from 1550 to 1650 cm⁻¹, and
   the D band has a full width at half maximum of 50 to 130 cm⁻¹.
[7] The member for exposure device according to any one of [1] to [6], wherein at least one surface of the member for exposure device is a polished surface.
[8] A method for producing the member for exposure device according to any one of [1] to [7], the method comprising:
   the step of forming a thermosetting resin material to prepare a resin formed body, and
   the step of carbonizing the resin formed body to obtain a glass-like carbon body.
[9] The method according to [8], wherein the method further comprises the step of making the resin formed body infusible by heating the resin formed body to increase a temperature of the resin formed body to 150°C or more, before the carbonizing step, and
   in the carbonizing step, the infusibilized resin formed body is carbonized at 900 to 3000°C.
[10] The method according to [8] or [9], wherein the method further comprises at least one of the steps of polishing the glass-like carbon body and the step of grinding the glass-like carbon body into an arbitrary shape.
[11] A composite member for exposure device, comprising: the member for exposure device according to any one of claims 1 to 7; and a part made of a material different from a material of the member for exposure device.
[12] A pellicle frame comprising the member for exposure device according to any one of [1] to [7].
[13] A composite pellicle frame comprising: the pellicle frame according to [12], and a part made of a material different from a material of the pellicle frame.

### Advantageous Effects of Invention

The present invention allows to provide a member for exposure device that is light and unlikely to thermally expand, a method for producing the member for exposure device, and a composite member for exposure device.

### Brief Description of Drawing

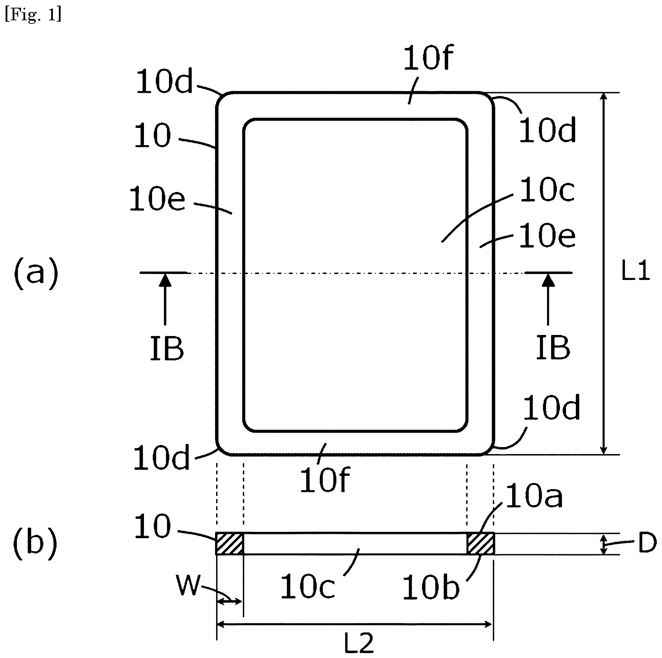

[Fig. 1] Fig. 1 is a schematic view illustrating the external appearance of an example of a pellicle frame as the member for exposure device according to an embodiment of the present invention. Fig. 1(a) is a plan view, and Fig. 1(b) is a cross sectional view taken along line IB-IB in Fig. 1(a).

### Description of Embodiments

The configuration and production method of the member for exposure device and the composite member for exposure device according to an embodiment of the present invention will now be described in this order. The member for exposure device is not limited to a pellicle frame and may be any member as long as it is used in exposure device, and it may be a stage part, a mirror part, a member for retaining an object to be exposed to light, such as a conveying arm, or another structural part, for example.

In the description below, surfaces of a pellicle frame are mentioned hereinafter with reference to figures and reference signs shown in figures as appropriate, for ease of understanding, but the present invention is not limited to the embodiment shown in the figures. The figures are illustrative and exaggerated for ease of understanding.

### 1. Member for Exposure Device

The member for exposure device according to an embodiment of the present invention includes glass-like carbon.

Examples of the member for exposure device include a movable part in exposure device, a part to be brought into contact with an object to be exposed to light such as a wafer, and a part facing the space in which an object to be exposed to light is placed. Examples of specific parts encompassed by the member for exposure device include a pellicle frame, a stage part having, for example, a platy shape, a mirror part for determination of a position having, for example, a disk shape, a member for retaining an object to be exposed to light, such as a conveying arm having a U-shaped conveying part, and other structural parts.

The glass-like carbon included in the member for exposure device is obtained by forming a thermosetting resin material into a prescribed shape to prepare a resin formed body and then heat-treating (carbonizing) the resin formed body at a high temperature. The step of forming to prepare a resin formed body (the forming step), the step of carbonizing the resin formed body to obtain a glass-like carbon body (the carbonizing step), and others will be described hereinafter.

The density of glass-like carbon is less than 60% based on the density of aluminum. The coefficient of linear expansion of the glass-like carbon is smaller than that of a resin or aluminum. For example, polyethylene, which is used for forming a resin pellicle frame as described above, has a coefficient of linear expansion of 110×10⁻⁶ to 130×10⁻⁶/K, and aluminum has a coefficient of linear expansion of about 24×10⁻⁶/K. Glass-like carbon may have a coefficient of linear expansion of, for example, 4.0×10⁻⁶/K or less, as described later.

Accordingly, a pellicle frame including glass-like carbon, which is one of the members for exposure device including glass-like carbon, is lighter than a pellicle frame made of a metal such as aluminum, which has been widely used conventionally, and also is unlikely to thermally expand as compared with (namely, have a smaller coefficient of linear expansion than) a resin pellicle frame and a metal pellicle frame.

In the case where a pellicle film is stretched and provided on the pellicle frame including glass-like carbon to provide a pellicle, the resulting pellicle enables to enhance its moving speed and provide easily handling thereof since the pellicle frame is light and also is unlikely to thermally expand. In addition, the pellicle film on the pellicle frame is unlikely to deform in patterning using a source of high energy light.

Namely, in the case where the member for exposure device including glass-like carbon is a movable part that can move in exposure device or a part to be brought into contact with an object to be exposed to light, such as a part for supporting an object to be exposed to light, weight reduction and small thermal expansion are both achieved. Accordingly, the capability to move at a high speed and ease of handling of the member for exposure device is enhanced, and the influence of the temperature increase on an object to be exposed to light and poor accuracy of the dimension in increasing the temperature is reduced.

Furthermore, glass-like carbon has a specific crosslinked structure and therefore highly uniform texture and also has a larger hardness than common graphite, whereby glass-like carbon is unlikely cause generation of dust due to the fall of particles.

As described above, the glass-like carbon constituting the member for exposure device is obtained by forming a thermosetting resin material into a prescribed shape to prepare a resin formed body and then heat-treating (carbonizing) the resin formed body at a high temperature. Since the glass-like carbon has already undergone the heat-treatment to be given thermal history at high temperatures, an extremely small amount of components fall from the grassy carbon even if it is heated by exposure to light. Accordingly, generation of foreign matter with growth potential (haze) that may cause failure of the patterning is suppressed.

In addition, glass-like carbon is close to an ideal black body, and is thus likely to suppress reflection of light. Advantageously, it is therefore easy to conduct an examination of the member for exposure device for foreign matter adhering to it, for example. It is known that an aluminum pellicle frame is blacken by alumite treatment in an acidic solution and by a dye. However, such an aluminum pellicle frame after alumite treatment has sulfate ions, nitrate ions, and the like remaining thereon which have been contained in the acidic solution. Accordingly, when such a pellicle frame is exposed to, for example, a high vacuum during use, nitrate ions and the like may desorb and react with ammonia to generate foreign matter with growth potential to cause failure of the patterning. In addition, since the surface of the alumite coating is porous, generation of dust easily occurs disadvantageously. In view of preventing these, it is also suggested to coat the aluminum or the alumite coating thereon with a polymer by electrodeposition coating, for example. However, another problem arises, and specifically, the electrodeposition coating film is peeled off by friction during handling or deteriorated by exposure to light.

As mentioned above, the member for exposure device including glass-like carbon is unlikely to generate dusts, and generates an extremely small amount of gas even in high vacuum or in an environment at a high temperature, and also the member itself is close to a black body. Accordingly, even in the case where the member for exposure device is a pellicle frame, it does not need an additional treatment or to be coated with a polymer film, unlike an aluminum pellicle frame.

A ceramic member for retaining a wafer, such as a conveying arm, has a larger surface hardness than the wafer and thus adversely affects the wafer by a shock when it contacts with the wafer. On the other hand, the member for retaining an object to be exposed to light, such as a conveying arm, including glass-like carbon has a smaller surface hardness than a ceramic member, and thus less affects the wafer.

Namely, when the member for exposure device including glass-like carbon is a part facing to the space in which an object to be exposed to light is placed, generation of dusts or gas is unlikely to occur so that the problem of generation of foreign matters is unlikely to arise.

The member for exposure device including glass-like carbon can also be polished so as to have a high flatness, as described hereinafter. Thus, in a case where the member for exposure device is a pellicle frame, elastic deformation of the pellicle frame is suppressed when a pellicle film is stretched and provided on the pellicle frame or when a photomask is adhered to the pellicle frame, and thus strain of the pellicle film or the photomask is suppressed.

As compared to a resin pellicle frame, the pellicle frame including glass-like carbon is advantageous in terms of the rigidity, and is thus unlikely to cause deformation or breakage of the pellicle film during preparation or use of the pellicle.

Glass-like carbon has great chemical resistance to all acids, bases, and organic solvents. Accordingly, the member for exposure device including glass-like carbon is unlikely to cause corrosion or the like, advantageously.

The glass-like carbon may include a component that is inevitably included therein due to the production thereof (e.g., ash), and the content of such a component is preferably small in view of allowing the glass-like carbon to exhibit the intended physical properties and preventing the elution of the impurities at high temperatures in high vacuum.

Here, the ash means components that are derived mainly from metal impurities and contaminate the glass-like carbon in the production process of the glass-like carbon. The "glass-like carbon" herein encompasses glass-like carbon that includes the ash.

The ash content in the glass-like carbon is preferably 50 ppm by mass or less, more preferably 20 ppm by mass or less, even more preferably 10 ppm by mass or less, and most preferably 5 ppm by mass or less, in view of suppressing the contamination with the impurities as much as possible and also preventing the elution thereof.

An ash content in the glass-like carbon within the above-described range can be achieved by, for example, selecting a thermosetting resin material of an appropriate type or designing the process so as to reduce the contamination with metal components when a thermosetting resin is heat-treated at a high temperature to obtain glass-like carbon.

The glass-like carbon constituting the member for exposure device preferably has a density of 1.6 g/cm³ or less, more preferably 1.58 g/cm³ or less, and even more preferably 1.56 g/cm³ or less, in view of weight reduction.

The lower limit of the density of the glass-like carbon is not particularly limited, and is, for example, 1.45 g/cm³ in view of ensuring the hardness of the glass-like carbon and sufficient crosslinked structure between carbon atoms, and in view of ease of production, for example.

The method for obtaining a density within the above-described numerical range may include, for example, setting the attained temperature as appropriate when a thermosetting resin is heat-treated at a high temperature to obtain glass-like carbon.

The glass-like carbon constituting the member for exposure device preferably has a Shore hardness (HS) of 100 or more, in view of easily suppressing generation of dust.

Glass-like carbon has a larger Shore hardness than that of common graphite (Shore hardness (HS): about 50 to 80). This is owing to characteristic crosslinked structure of glass-like carbon. When glass-like carbon has a Shore hardness (HS) of 100 or more, the glass-like carbon has highly uniform texture due to the growth of the crosslinked structure, and is thus unlikely to cause generation of dust due to the fall of particles, unlike graphite. Accordingly, even when the member for exposure device including glass-like carbon is brought into contact with another member, less generation of particles occurs due to friction.

The glass-like carbon constituting the member for exposure device more preferably has a Shore hardness (HS) of 100 to 150, further preferably 110 to 140, and even more preferably 115 to 135.

The Shore hardness (HS) herein is a value as measured Shore durometer of type D, and specifically measured by the method described in Examples.

The method for obtaining a Shore hardness (HS) within the above-described numerical range may include, for example, setting the heat-treatment temperature as appropriate when a thermosetting resin is heat-treated at a high temperature to obtain glass-like carbon.

The glass-like carbon constituting the member for exposure device preferably has a coefficient of linear expansion at 200°C of 4.0×10⁻⁶/K or less, more preferably 3.5×10⁻⁶/K or less, and even more preferably 3.0×10⁻⁶/K or less, in view of suppression of change in dimension of the member for exposure device and reduction of influence on members other than the member for exposure device, for example.

For example, in a case where the member for exposure device is a pellicle frame, it is easy to suppress change in dimension of the pellicle and to ensure the adhesion of the pellicle frame to the pellicle film, when the glass-like carbon has a coefficient of linear expansion within the above-described range. For example, in a case where the member for exposure device is a stage part, it is easy to ensure the accuracy of the operation of the stage part and to ensure the accuracy of the dimension of the whole of a member for retaining an object to be exposed to light, when the glass-like carbon has a coefficient of linear expansion within the above-described range.

The lower limit of the coefficient of linear expansion is not particularly limited, and is, for example, 2.0×10⁻⁶/K in view of ensuring, for example, the hardness of the glass-like carbon and sufficient crosslinked structure between carbon atoms, and also in view of ease of production.

The method for obtaining a coefficient of linear expansion within the above-described numerical range may include, for example, setting the attained temperature as appropriate when a thermosetting resin is heat-treated at a high temperature to obtain glass-like carbon.

In view of the sufficient growth of crosslinked structure between carbon atoms to easily obtain the properties including a small density and small thermal expansion, the glass-like carbon constituting the member for exposure device preferably has a peak intensity ratio I_{D}/I_{G} of 1.0 to 2.5 in the Raman spectrum, wherein I_{D} represents a peak intensity of a D band within a range from 1300 to 1400 cm⁻¹, and I_{G} represents a peak intensity of a G band within a range from 1550 to 1650 cm⁻¹, and at the same time the D band preferably has a full width at half maximum of 50 to 130 cm⁻¹.

The D band is a peak derived from defects of graphite structure, and the G band is a peak derived from an ideal graphite structure as a carbon material. A value of I_{D}/I_{G} of 1 or more and, at the same time, a full width at half maximum of the D band within the above-described range mean that the glass-like carbon has much disorder/crosslinked structure in carbon structure, and that crystal growth thereof less proceeds than graphite. Thus, when I_{D}/I_{G} and a full width at half maximum of the D band are within the above-described respective ranges, the properties including a small density and small thermal expansion are easily obtainable due to the sufficient growth of the crosslinked structure between carbon atoms.

I_{D}/I_{G} is more preferably 1.0 to 2.0, and the full width at half maximum of the D band is more preferably 70 to 130 cm⁻¹.

The method for obtaining a peak intensity ratio I_{D}/I_{G} within the above-described numerical range may include, for example, setting the attained temperature as appropriate when a thermosetting resin is heat-treated at a high temperature to obtain glass-like carbon.

Among surfaces of the member for exposure device, at least one surface is preferably a polished surface.

For example, in a case where the member for exposure device is a pellicle frame, at least one of the pellicle film-setting surface and the mask-bonding surface is preferably a polished surface. In a case where the member for exposure device is a stage part or a member for retaining an object to be exposed to light, such as a conveying arm, the surface to be brought into contact with an object to be exposed to light is preferably a polished surface. In a case where the member for exposure device is a mirror part, the surface including the region serving as a mirror surface is preferably a polished surface.

The polished surface may be a surface having a predetermined surface roughness, or may be a mirror-finished surface. The "mirror-finished surface" herein means a surface that has undergone mirror-finishing with s polishing agent such as abrasive grains for mirror-finishing.

The member for exposure device may consist of a member for exposure device made of glass-like carbon, or may be a composite including the above-described member for exposure device and another part made of a material different from the material of the member for exposure device, as described later. Herein, the composite is referred to as a "composite member for exposure device". The composite member for exposure device will be described later.

The member for exposure device may consist only of glass-like carbon, or the member for exposure device may include another component in addition to glass-like carbon for the purpose of improving the strength and other physical properties of the member for exposure device.

Examples of the other component include carbon fiber, graphite, and silicon. The content of the component other than the glass-like carbon in the member for exposure device is preferably 50 mass% or less, more preferably 20 mass% or less, even more preferably 5 mass% or less, in view of ensuring, for example, the hardness of the glass-like carbon and sufficient crosslinked structure between carbon atoms, and also in view of ease of production.

### 2. Pellicle Frame

The pellicle frame according to an embodiment of the present invention is one of the above-described members for exposure device.

The pellicle frame may consist of a pellicle frame, or may be a composite including the pellicle frame and a part made of a material different from the material of the pellicle frame. Herein, the composite is referred to as a "composite pellicle frame". The composite pellicle frame will be described later.

An example of the pellicle frame according to an embodiment of the present invention is now shown in Fig. 1.

As shown in the plan view of Fig. 1(a), pellicle frame 10 shown in Fig. 1 has a rectangular frame shape in planar view, and an opening 10c is formed in the center portion thereof. Each corner 10d, at which a long straight line portion 10e and a short straight line portion 10f intersect each other, has a corner radius. The pellicle frame may include a spot-facing or a through hole described later, though they are not shown in Fig. 1.

Among two surfaces positioned in the thickness direction of pellicle frame 10, one is a pellicle film-setting surface 10a, on which a pellicle film is to be provided, and the other is a mask-bonding surface 10b, to which a photomask is to be bonded, as shown in the cross sectional view of Fig. 1(b).

Pellicle frame 10 may have an adhesive layer or a sticking layer on pellicle film-setting surface 10a or mask-bonding surface 10b though illustration of these layers is omitted in Fig. 1(b).

The pellicle frame including glass-like carbon is lighter than a metal pellicle frame, and is unlikely to thermally expand as compared with a resin pellicle frame and a metal pellicle frame. Accordingly, in the case where a pellicle film is stretched and provided thereon to obtain a pellicle, the pellicle is movable at an improved speed so that the pellicle is excellent in ease of handling. In addition, the pellicle film is unlikely to deform even in patterning using a source of high energy light. Also, the pellicle frame including glass-like carbon is unlikely to cause generation of dust due to the fall of particles, because of the crosslinked structure characteristic to the glass-like carbon, and since the pellicle frame including glass-like carbon has undergone a thermal history at high temperatures in its production, the amount of components desorbed when heated is extremely small. Furthermore, the pellicle frame including glass-like carbon is advantageous in terms of the rigidity as compared to a resin pellicle frame, and is thus unlikely to cause deformation or breakage of the pellicle film during preparation or use of the pellicle. In addition, the pellicle frame including glass-like carbon is unlikely to cause corrosion or the like because of its great chemical resistance, and is likely to suppress reflection of light since the glass-like carbon is close to an ideal black body.

In the pellicle frame, at least one surface of the pellicle film-setting surface (reference 10a in Fig. 1(b)) and the mask-bonding surface (reference 10b in Fig. 1(b)) is preferably a polished surface.

More preferably, both of the pellicle film-setting surface and the mask-bonding surface are polished surfaces. The polished surface may be a mirror-finished surface.

When at least one of the pellicle film-setting surface and the mask-bonding surface is a polished surface, the surface becomes smooth to enhance the flatness. As a result, the flatness of the pellicle frame is enhanced so that the strain when a pellicle film or a photomask is bonded is easily suppressed.

The flatness of the pellicle frame is preferably 50 µm or less in view of suppressing elastic deformation of the frame upon stretching and providing a pellicle film on the pellicle frame or upon bonding a photomask on the pellicle frame to thereby suppress the strain of the pellicle film or the photomask.

In the case where the pellicle frame is a polygonal frame shape, the flatness of the pellicle frame herein is a value calculated in the following procedure: the height is measured at each corner of the pellicle frame and all of the straight line portions (references 10e, 10f in Fig, 1(a)) between the pair of the adjacent corners (references 10d in Fig, 1(a)); a virtual plane is derived from the found heights by least-squares method; among the distances from the virtual plane at the respective measurement points, the difference obtained by subtracting the distance at the lowest point from that of the highest point is used as the flatness. The flatness is specifically determined by the method described in Examples.

The method for obtaining a flatness within the above-described numerical range may include, for example, polishing the pellicle film-setting surface or mask-bonding surface of the pellicle frame including glass-like carbon.

The shape of the pellicle frame in the plan view is not particularly limited to a rectangular frame shape as shown in Fig. 1(a) and may be any shape. For example, it may be a polygonal frame shape such as a square or hexagonal frame shape.

The size of the pellicle frame in the plan view is not limited, and may be an appropriate size according to, for example, the size of the region to be exposed to light and the configuration of the exposure device, also taking ease of production or the like into account. For a rectangular pellicle frame, the length of the outer shape (see reference L1 in Fig. 1(a)) may be 50 to 300 mm; the width of the outer shape (see reference L2 in Fig. 1(b)) may be 50 to 300 mm; and the width of the frame portion (see reference W in Fig. 1(b)) may be 1 to 50 mm.

The thickness (see reference D in Fig. 1(b)) of the pellicle frame is also not particularly limited, and may be an appropriate thickness according to, for example, the strength and the specification of the device to which the pellicle frame is introduced, also taking ease of production or the like into account. The thickness of the pellicle frame may be, for example, 0.5 to 6.0 mm.

The shape of the pellicle frame according to an embodiment of the present invention is, for example, a polygonal frame shape and has corners. Typically, the pellicle frame has a quadrangular frame shape such as a rectangular frame shape. The corner at which the straight line portions of the pellicle frame intersect each other may have a corner radius as with corners 10d shown in Fig. 1(a), or may be beveled with a flat surface extending in the thickness direction (the direction indicated by reference D in Fig. 1(b)). The pellicle frame may also include a through hole or a spot-facing, for example. The through hole can be used to allow air to pass through it, for example. The spot-facing can be used as a grip portion or positioning portion upon conveyance, for example.

### 3. Method for Producing Member for Exposure Device

The member for exposure device according to an embodiment of the present invention can be produced by a production method including the steps of:
- forming a thermosetting resin material to prepare a resin formed body (the forming step)
- carbonizing the resin formed body to obtain a glass-like carbon body (the carbonizing step).

The method for producing the member for exposure device preferably further includes at least one of the steps of polishing the glass-like carbon body (the polishing step) and the step of grinding the glass-like carbon body into an arbitrary shape (the grinding step).

For example, in the case where the member for exposure device is a pellicle frame, at least one of the pellicle film-setting surface and the mask-bonding surface is preferably processed in the polishing step. In the case where the member for exposure device is a stage part, the surface on which an object to be exposed to light is placed is preferably processed in the polishing step. In the case where the member for exposure device is a mirror part, the surface including the region serving as a mirror surface is preferably processed in the polishing step. In the case where the member for exposure device is a member for retaining an object to be exposed to light, such as a conveying arm, the surface to be brought into contact with an object to be exposed to light is preferably processed in the polishing step.

By processing each surface described above into a polished surface through the polishing step, these surfaces can be controlled to have an arbitrary roughness such that each surface has a high flatness or a predetermined surface roughness. For example, in the case where the member for exposure device is a pellicle frame, increase in the flatness of the pellicle film-setting surface or the mask-bonding surface enables to unlikely cause the strain or the like in the reticle film or the photo mask. In the case where the member for exposure device is a stage part or a member for retaining an object to be exposed to light, such as a conveying arm, the influence thereof on an object to be exposed to light can be reduced easier by allowing the surface to be into contact with an object to be exposed to light to have a prescribed roughness. In the case where the member for exposure device is a mirror part, the exposure light becomes to reflect with high accuracy on the mirror surface and less reflect on the other region, by increasing the flatness of the region serving as the mirror surface and giving the other region a predetermined surface roughness, and it is thus easy to reflect the exposure light in an intended manner.

For example, in the case where the member for exposure device is a pellicle frame, the formation of the contour of the pellicle frame, the processing into a frame shape, and the formation of a through hole or a spot-facing, for example, can be carried out in the grinding step. In the case where the member for exposure device is a stage part, a mirror part, or a member for retaining an object to be exposed to light, such as a conveying arm, the processing for formation of the contour of these parts can be carried out in the grinding step, for example.

The order of the polishing step and the grinding step is not particularly limited. For example, (i) the polishing step may be followed by the grinding step; or (ii) the grinding step may be followed by the polishing step. (iii) At least part of the polishing step and at least part of the grinding step may be carried out simultaneously.

In case (i), polishing is carried out relatively easily in the polishing step. In case (ii), the portion to be polished in the polishing step can be reduced. In case (iii), it is easy to shorten the time necessary for the whole steps.

The order of the carbonizing step, and the polishing step and the grinding step is also not particularly limited. For example, (iv) the carbonizing step may be followed by the polishing step and the grinding step; (v) at least part of the polishing step may be carried out before the carbonizing step; or (vi) at least part of the grinding step may be carried out before the carbonizing step.

In case (iv), the operation in the carbonizing step and the setting of the conditions for production are easy. In cases (v) and (iv), it is easy to simplify a step carried out after the carbonizing step.

Herein, the glass-like carbon body before subjecting the polishing step and the grinding step, the glass-like carbon body obtained by carbonizing the resin formed body, may also be referred to as a "precursor of the member for exposure device"

Preferably, the method for producing the member for exposure device further includes the step of making the resin formed body infusible by heating the resin formed body to increase the temperature of the resin formed body to 150°C or more, before the carbonizing step. In addition, in the carbonizing step, the infusibilized resin formed body is preferably carbonized at 900 to 3000°C.

In this case, the order of the step of making the resin formed body infusible, and the polishing step and the grinding step is also not particularly limited.

### [Forming Step]

In the forming step, a thermosetting resin material serving as a carbon source of glass-like carbon is formed to prepare a resin formed body.

The starting material for the glass-like carbon is a thermosetting resin material including a resin component that becomes non-graphitizable carbon through heat-treatment. Specifically, examples thereof include a phenol-formaldehyde resin, a furan resin, and a polycarbodiimide resin.

The thermosetting resin material is generally in the form of a powder or a liquid. Accordingly, it is desirable to use a forming method suitable for the form of the resin, such as molding or casting, to shape the resin to obtain a resin formed body.

For obtaining a dense resin formed body suitable for the member for exposure device, it is desirable to use a liquid thermosetting resin material as the above-described thermosetting resin material, pouring the liquid thermosetting resin material into a mold, and heating it to a predetermine temperature to carry out casting to thereby prepare a resin formed body. The liquid thermosetting resin material may include a resin component and a solvent.

Examples of the liquid thermosetting resin material include a resol phenol-formaldehyde resin solution, a polycarbodiimide resin solution, and a furfuryl alcohol polymer.

Examples of the solvent used with the resin component include an alcohol such as methanol, a chlorinated organic solvent such as perchloroethylene, toluene, N,N-dimethylformamide (DMF), and water. An alcohol such as methanol, toluene, DMF, and water are preferable in view of shapability, for example.

In the forming step, it is preferable to heat the thermosetting resin material with an air-permeable member in contact with a part thereof.

It is more preferable to spread the thermosetting resin material in a plate-like form and heat the thermosetting resin material with a sheet-like air-permeable member in contact with at least one surface of the thermosetting resin material in a plate-like form. It is also possible to heat the thermosetting resin material interposed between a pair of sheet-like air-permeable members. An air-permeable member that has a shape to surround the thermosetting resin material may be used, and the thermosetting resin material may be heated with the inner circumference of such an air-permeable member in contact with the thermosetting resin material. The air-permeable member that has a shape to surround the thermosetting resin material and the sheet-like air-permeable member may be used in combination.

It is preferable to use a liquid thermosetting resin material as the thermosetting resin material, pour the liquid thermosetting resin material into a mold, and heat to a predetermined temperature to carry out casting to thereby form a solid resin formed body in the forming step.

When the thermosetting resin material is heated with an air-permeable member in contact therewith, the thermosetting resin material is heated uniformly and also degassed uniformly through the air-permeable member. Particularly, when the thermosetting resin material spread in a plate-like form is heated with a sheet-like air-permeable member in contact with at least one surface of the thermosetting resin material, uniform heating and degassing are achieved on the surface in contact with the air-permeable member. Due to such uniform heating and degassing, a homogeneous glass-like carbon body is easily obtainable, and also a crack or the like is difficult to generate in the thermosetting resin material by gas remaining inside.

In the forming step, it is preferable to heat while gradually increasing the temperature to the predetermined attained temperature, in view of preventing generation of bubbles by volatilization of the solvent. The attained temperature can be set according to, for example, the vapor pressure and the boiling point of the solvent included in the resin solution. The heating time to reach the attained temperature is preferably 10 to 50 hours according to, for example, the size of the formed body.

Examples of the sheet-like air-permeable member include a sheet made of water-repellent fibers, such as a mesh filter. The sheet-like air-permeable member may be cut and processed into a frame shape, or processed into ribbons, followed by combining a plurality thereof before use. Thus an air-permeable member that has a shape to surround the thermosetting resin material can be obtained.

A resin formed body having an arbitrary shape may be prepared in the forming step to thereby skip or simplify the grinding step described later. For example, in the case where a pellicle frame is prepared as the member for exposure device, a resin formed body having a frame shape may be prepared in the forming step to thereby skip or simplify the grinding step described later. In other words, the member for exposure device may be produced by the method including preparing a resin formed body having an arbitrary shape, such as a frame shape, in the forming step and excluding the grinding step, or the amount of processing in the grinding step may be rendered small by preparing a resin formed body having an arbitrary shape, such as a frame shape, in the forming step.

### [Step of Making Resin Formed Body Infusible]

In view of enhancing the chemical stability of the resin formed body, it is preferable to carry out the step of making the resin formed body infusible by heating the resin formed body to increase the temperature of the resin formed body to 150°C or more, before the carbonizing step.

Through the step of making the resin formed body infusible, the resin component is cured so that the resin formed body obtained by forming the thermosetting resin material becomes a cured resin formed body.

In the step of making the resin formed body infusible, heating is carried out such that the attained temperature is more preferably 170°C or more and even more preferably 200°C or more, though a preferable temperature varies according to the type of the resin, for example.

The atmosphere when heating is not particularly limited, and for example, heating can be carried out under air.

Examples for device used for making the resin formed body infusible include a natural convection dryer, a forced convection dryer, and a hot plate.

### [Coating step]

Before the carbonizing step, it is possible to carry out the step of coating the infusibilized resin formed body with an antistatic agent. Carrying out the coating step easily prevents contamination of the member for exposure device with impurities and formation of pores in the member for exposure device due to adhesion of a trace amount of metal components included in the environment.

Examples of the antistatic agent include an ionic surfactant and a nonionic surfactant.

Examples of the ionic surfactant include a cationic surfactant, an anionic surfactant, and an amphoteric surfactant.

### [Carbonizing Step]

In the carbonizing step, the resin formed body, preferably the infusibilized resin formed body, is carbonized at a high temperature to thereby obtain a glass-like carbon body (precursor of the member for exposure device).

The carbonizing step is preferably carried out under inert gas such as nitrogen or argon, or in vacuo at about 10⁻³ to 10⁻¹ Torr.

The carbonizing step preferably include the first substep of heating at 900 to 1100°C and the second substep of heating at a higher temperature than in the first heating substep. In the second heating step, the characteristic of the crystal of the resulting glass-like carbon can be regulated by heating to a temperature higher than 1100°C and not higher than 3000°C and controlling the heating temperature and the retaining time.

In the second heating step, heating may be carried out while a purified gas such as chlorine gas is allowed to flow, to thereby obtain a highly pure glass-like carbon.

Examples of the purified gas include fluorine gas, chlorine gas, dichlorodifluoromethane, dichlorofluoromethane, and carbon tetrachloride.

The carbonizing temperature in the first heating step is preferably 900 to 1100°C, more preferably 930 to 1050°C, and even more preferably 950 to 1000°C, in terms of the attained temperature, in view of the uniformity and prevention of cracks and splits in the resulting glass-like carbon body. The carbonizing temperature in the second heating step is preferably 1100 to 3000°C, more preferably 1150 to 2500°C, and even more preferably 1200 to 2000°C, in terms of the highest temperature, in view of the carbon structure and control of its physical properties.

The device for carrying out carbonizing is not particularly limited as long as it is device capable of reaching the above-described carbonizing temperature in the above-described atmosphere, and various device can be used. Examples thereof include an electric furnace, Riedhammer furnace, and a vacuum furnace.

In view of prevention of cracks/splits and contamination with impurities of the resulting glass-like carbon body, it is preferable to obtain a resin formed body in the forming step described above, further to carry out the step of making the resin formed body infusible and the coating step, and then to carry out the carbonizing step.

The glass-like carbon body obtained from the thermosetting resin material described above as the starting material through forming and carbonizing has a crosslinked structure characteristic to glass-like carbon. Glass-like carbon having grown crosslinked structure has highly uniform texture and is thus unlikely to cause generation of dust due to the fall of particles, unlike graphite. As a result, it is easy to suppress generation of particulates due to friction.

The formation of a glass-like carbon is determined by presence/absence of the D band and the G band as described above in the Raman spectrum obtained by Raman spectroscopy.

The method for allow the crosslinked structure to grow to enhance the uniformity of the texture may include making the texture of the resin formed body uniform by setting the rate of temperature increase as appropriate in the heat-treatment in the forming step and/or the step of making the resin formed body infusible or by using the air-permeable member in the forming step; or setting the rate of temperature increase and/or the attained temperature as appropriate in the carbonizing step.

### [Polishing Step]

In the polishing step, lapping or polishing is carried out to obtain a precursor of the member for exposure device with a desirable flatness. In addition, adjustment of the grain size of the abrasive grain enables finish to an arbitrary surface roughness.

The polishing step may be carried out by two substeps, and may include: the first polishing substep of processing a surface of the glass-like carbon body that is to be the pellicle film-setting surface or the mask-bonding surface such that the glass-like carbon has a predetermined thickness; and the second polishing substep of further processing the surface of the glass-like carbon to a predetermined surface roughness or less.

The first polishing substep can be carried out by, for example, polishing to a depth of 0.3 to 3.0 mm using a polishing machine such as a lapping machine with a SiC or B₄C abrasive grain with a grain size of #1000 to #2000.

The second polishing substep can be carried out by, for example, performing mirror-finishing with an alumina-based or diamond-based abrasive grain for mirror-finishing.

In the second polishing substep, the abrasive grain used is for mirror-finishing and thus very fine, which can reduce the depth of the damage of the surface of the glass-like carbon body due to the polishing or reduce the thickness of the denatured layer (the depth of denaturation) formed on the surface of the glass-like carbon body due to the polishing.

For example, in the case where the member for exposure device is a pellicle frame, the flatness of the pellicle film-setting surface and/or the mask-bonding surface described above can be improved by processing the pellicle film-setting surface and/or the mask-bonding surface into a polished surface through the above-described polishing step.

### [Grinding Step]

In the grinding step, the glass-like carbon body is ground. For example, in the case where the member for exposure device is a pellicle frame, the glass-like carbon body is ground into a frame shape, or a through hole or a spot-facing is formed in the glass-like carbon body. In the grinding step, a corner may be processed so as to be given a corner radius as with corner 10d of pellicle frame 10 shown in Fig. 1(a).

Any tools can be used for the grinding, and for example, machining center having a grinding tool with large hardness can be used.

In the case of a member for retaining an object to be exposed to light, such as a conveying arm, the surface to be brought into contact with a wafer may be tapered.

### 4. Composite Member for Exposure Device

The composite member for exposure device according to an embodiment of the present invention includes: the member for exposure device described above; and a part made of a material different from the material of the member for exposure device.

The composite pellicle frame according to an embodiment of the present invention includes: the pellicle frame described above; and a part made of a material different from the material of the pellicle frame.

For forming each part described above, examples of the material different from the material of the member for exposure device and the material different from the material of the pellicle frame include aluminum, resin, and stainless steel.

The shape of each part described above is not particularly limited, and a part in any shape can be used. For example, the part may have the same shape as that of the member for exposure device in the plan view. In the case of a composite pellicle frame, the shape of the part may be the same frame shape as that of the pellicle frame.

For example, in the case the member for exposure device is a pellicle frame, the part is provided via an adhesive layer or a sticking layer on at least one surface of the pellicle film-setting surface and the mask-bonding surface of the pellicle frame, for example.

Due to the part provided, the composite member for exposure device and the composite pellicle frame tends to have a larger strength and rigidity than the member for exposure device and the pellicle frame, respectively.

### Examples

The present invention will now be described in more detail by way of examples, however, the present invention is not limited by these examples at all.

Measurements and evaluations were carried out in the manners described below, for the physical properties of the glass-like carbon used for the production of the pellicle frames according to Examples and the physical properties of the pellicle frames according to Examples.

### <Density>

The mass and the volume of the glass-like carbon body serving as a precursor of a member for exposure device were measured. The former was divided by the latter, and the resulting value was used as the density of the glass-like carbon constituting the member for exposure device.

### <Shore Hardness>

The Shore hardness (HS) was measured at five different arbitrary points on the edge surface of the glass-like carbon body using a Shore durometer of type D manufactured by IMAITESTER, and the average thereof was used as the Shore hardness (HS) of the glass-like carbon.

### <Coefficient of Linear Expansion>

The coefficient of linear expansion was determined using a thermomechanical analyzer TMA 8310 (manufactured by Rigaku Corporation). SiO₂ with a size of φ5 × 10 mm was used as the reference sample. A measurement sample was prepared by grinding a precursor of a member for exposure device into φ5 × 10 mm. The measurement was carried out under the condition that the temperature was increased up to 200°C at 10°C/min under nitrogen flow. The coefficient of linear expansion was calculated from the change in the height of the test piece.

### <Ash Content>

A precursor of a member for exposure device was pulverized into the form of a powder for easily turning to ash and then placed in a platinum crucible, and the weight of the sample before treatment was measured. The sample was turned to ash in oxygen at 800°C in a muffle furnace. It was checked that no carbon residue remained, and the weight of the remaining as ash was measured. The content of ash included in the precursor of a member for exposure device was calculated.

### <Raman Peak Intensity Ratio>

Raman spectroscopy was carried out on the main surface of each sample using Raman laser micro-spectrometer (Lab RAM, manufactured by HORIBA Scientific) with Nd:YVO₄ laser at 532 nm. The peak intensity ratio I_{D}/I_{G} was calculated from the peak intensity of the D band within a range from 1300 to 1400 cm⁻¹, I_{D}, and the peak intensity of the G band within a range from 1550 to 1650 cm⁻¹, I_{G}, in the resulting Raman spectrum.

### <Accelerated Exposure Test>

The accelerated exposure test was carried out for a precursor of a member for exposure device using ArF excimer laser. The test was conducted under the conditions as follows: ArF laser at 193 nm, power 3 mJ/cm³, and total light exposure 1 kJ. The surface of the precursor of a member for exposure device was observed under an optical microscope, before the start of the test and after the completion of the test, and it was checked whether any change between the surface before the exposure and that after the exposure was found.

### <Ion Elution Test>

The precursor of a member for exposure device was immersed in deionized water, and left stand at 90°C for 2 hours. Then, the amount of desorbed ions eluted in the deionized water was quantified by ion chromatography.

### <Flatness of Precursor of Member for Exposure Device>

The flatness of a precursor of a member for exposure device was determined in the following procedure. The height of the precursor of the member for exposure device was measured at each corner and at points at 5-mm intervals in the straight line portions between the pair of the adjacent corners; a least square plane (virtual plane) was calculated; and among the distances at the measurement points, the difference obtained by subtracting the distance at the farthest point below the least square plane (the lowest point) from that of the farthest point above the least square plane (the highest point) was calculated; and the resulting value was used as the flatness of the precursor of a member for exposure device.

### [Production Example 1]

A resol phenol-formaldehyde resin solution in methanol was used as a thermosetting resin material. Two sheets of fluororesin non-woven fabric serving as sheet-like air-permeable members were provided, and a polytetrafluoroethylene (PTFE)-coated aluminum mold for defining the side surfaces was placed between these upper and lower non-woven fabric sheets. Then, the above-described thermosetting resin material was spread in the mold to carry out casting, thereby preparing a resin formed body in the form of square plate having a length of 250 mm, a width of 250 mm, and a thickness of 5 mm. The casting was achieved by gradually increasing the temperature from room temperature to 90°C over 20 hours in an oven. The upper and lower non-woven fabric sheets and the mold were removed. The temperature was then increased from 90°C to 200°C over 30 hours in the oven to heat the resin formed body, thereby curing the resin formed body, and the cured resin formed body was further made infusible to obtain an cured resin formed body.

In vacuum atmosphere at 0.01 Torr in a vacuum furnace, the cured resin formed body was heat-treated by gradually increasing the temperature from room temperature to 1000°C in the first heating sub-step, and furthermore heat-treated by gradually increasing the temperature from 1000°C to 1750°C in the second heating sub-step to thereby obtain a glass-like carbon body made of glass-like carbon in the form of square plate having a length of about 200 mm, a width of about 200 mm, and a thickness of about 4 mm.

The measurement results of the above-described physical properties of the glass-like carbon body are shown in Table 1. For the purpose of reference, table 1 also shows the density, the Shore hardness (HS), and the coefficient of linear expansion of aluminum (A5052) as Reference Example 1 and polyethylene (HDPE) as Reference Example 2.

The Shore hardness in Reference Example 1 was a value determined by the same method as in Example 1. The density and the coefficient of linear expansion in Reference Examples 1 to 3 are general values found in dictionaries and various literatures.

**Table 1**

| Material/ Item of Measurement or Evaluation | Unit | Production Example 1 | Reference Example 1 | Reference Example 2 | Reference Example 3 |
|---|---|---|---|---|---|
| Material | - | Glass-like Carbon Body | Aluminum (A5052) | Polyethylene (HDPE) | Alumina (A479M) |
| Density | g/cm³ | 1.55 | 2.68 | 0.94∼0.97 | 3.9 |
| Shore Hardness | HS | 127 | 14 | - | - |
| Coefficient of Linear Expansion | ×10⁻⁶ K⁻¹ | 2.5 | 24 | 110∼130 | 7.2 |
| Ash Content | ppm | 3.0 | - | - | - |
| Raman Peak Intensity Ratio (I_{D}/I_{G}) | - | 1.86 | - | - | - |
| Full Width at Half Maximum of Raman D Band | cm⁻¹ | 75.5 | - | - | - |
| Accelerated Exposure Test | - | No change | - | - | - |
| Amount of Ions Eluted | ppb | SO₄²⁻:≤5 | - | - | - |
| | | NH₄⁺:≤15 | | | |

As shown in Table 1, the glass-like carbon material according to Production Example 1, which was prepared through the above-described steps, has a value of the Raman peak intensity ratio I_{D}/I_{G} of 1.86, which is not less than 1, and a full width at half maximum of the Raman D band of 75.5 cm⁻¹, which is within a range from 50 to 130 cm⁻¹. It can be seen from these that disorder was formed in the carbon crystal structure, and that the uniformity of the texture is enhanced due to the growth of the crosslinked structure. As clear from comparison with aluminum, the glass-like carbon body according to Production Example 1 has a large Shore hardness and a small coefficient of linear expansion, and the coefficient of linear expansion of the glass-like carbon body according to Production Example 1 is also smaller than that of polyethylene or alumina. Thus, it is found that the glass-like carbon body according to Production Example 1 is constituted with a glass-like carbon which is suitable for a member for exposure device.

As obvious from comparison between Production Example 1 and Reference Example 1, it is also appreciated that the glass-like carbon body according to Production Example 1 has a smaller density than that of aluminum and can thus remarkably reduce the weight of a member for exposure device.

As obvious from comparison between Production Example 1 and Reference Example 3, it is also appreciated that the glass-like carbon body according to Production Example 1 has a smaller coefficient of linear expansion and also a smaller density than those of a ceramic, and that the accuracy of the position can be improved when it is used for a stage part, a mirror part, or a member for retaining an object to be exposed to light, such as a conveying arm.

As a result of the accelerated exposure test, no change was found on the surface of the precursor of a member for exposure device according to Production Example 1 even after exposure, as shown in Table 1, and it can be seen that the precursor of a member for exposure device including glass-like carbon has high light resistance.

As a result of the ion elution test, the amount of SO₄²⁻ was 5 ppb or less and the amount of NH₄⁺ was 15 ppb or less, as shown in Table 1. It can be seen that the amounts of components eluted from the precursor of a member for exposure device according to Production Example 1 are extremely small.

### [Example 1]

The glass-like carbon body prepared in Production Example 1 was subjected to polishing and grinding in the following procedure to prepare a pellicle frame according to Example 1.

In the first processing, the pellicle film-setting surface and mask-bonding surface of the glass-like carbon body were each polished for 0.5 mm or more using a lapping machine with a SiC abrasive grain of #1000. In the second processing, the resulting pellicle film-setting surface and mask-bonding surface were each mirror-finished with an alumina-based abrasive grain for mirror-finishing, to finish the glass-like carbon body to a thickness of 3 mm.

The thus obtained glass-like carbon body with its upper and lower surfaces mirror-finished was ground using machining center having a diamond tool to thereby finish the glass-like carbon body to a length and width of the outer shape (L1 and L2 in Fig. 1(b)) of 150 mm and 110 mm, respectively, and a width of the frame portion (W in Fig. 1(b)) of 2 mm. Additionally, at each of a position between the center and one edge and another position between the center and the other edge, the positions being symmetrical with respect to the center, on each straight line portion of the frame in the plane view, a spot-facing having a diameter of 1.5 mm and a depth of 1 mm was formed in the width direction (direction W in Fig. 1(b)) of the frame from the center in the thickness direction (direction D in Fig. 1(b)) on the side surface of the outer shape. In this way, a pellicle frame was prepared.

The pellicle frame including the glass-like carbon according to Example 1 obtained through the polishing and grinding as described above had a flatness less than 20 µm.

Taking the density (2.68 g/cm³) and the coefficient of linear expansion (about 24 × 10⁻⁶/K) of aluminum into account, the pellicle frame according to Example 1 has a smaller mass, by about 40% or more, than an aluminum pellicle frame having the same shape, and also can suppress the linear expansion to about 10% of the linear expansion of the aluminum pellicle frame, when increasing the temperature from room temperature to 200°C. The linear expansion can also be suppressed to about 2% of a polyethylene pellicle frame (coefficient of linear expansion: 110×10⁻⁶ to 130×10⁻⁶/K) having the same shape as a resin pellicle frame.

### Reference Signs List

10: pellicle frame
10a: pellicle film-setting surface
10b: mask-bonding surface
10c: opening

## Claims

1. A member for exposure device, comprising glass-like carbon.

2. The member for exposure device according to claim 1, wherein the glass-like carbon has a density of 1.6 g/cm³ or less.

3. The member for exposure device according to claim 1 or 2, wherein the glass-like carbon has a Shore hardness (HS) of 100 or more.

4. The member for exposure device according to any one of claims 1 to 3, wherein the glass-like carbon has a coefficient of linear expansion of 4.0×10⁻⁶/K or less.

5. The member for exposure device according to any one of claims 1 to 4, wherein the glass-like carbon has an ash content of 50 ppm by mass or less.

6. The member for exposure device according to any one of claims 1 to 5, wherein in a Raman spectrum of the glass-like carbon,
a peak intensity ratio I_{D}/I_{G} is 1.0 to 2.5, wherein I_{D} represents a peak intensity of a D band within a range from 1300 to 1400 cm⁻¹, and I_{G} represents a peak intensity of a G band within a range from 1550 to 1650 cm⁻¹, and
the D band has a full width at half maximum of 50 to 130 cm⁻¹.

7. The member for exposure device according to any one of claims 1 to 6, wherein at least one surface of the member for exposure device is a polished surface.

8. A method for producing the member for exposure device according to any one of claims 1 to 7, the method comprising:
the step of forming a thermosetting resin material to prepare a resin formed body, and
the step of carbonizing the resin formed body to obtain a glass-like carbon body.

9. The method according to claim 8, wherein the method further comprises the step of making the resin formed body infusible by heating the resin formed body to increase a temperature of the resin formed body to 150°C or more, before the carbonizing step, and
in the carbonizing step, the infusibilized resin formed body is carbonized at 900 to 3000°C.

10. The method according to claim 8 or 9, wherein the method further comprises at least one of the steps of polishing the glass-like carbon body and the step of grinding the glass-like carbon body into an arbitrary shape.

11. A composite member for exposure device, comprising: the member for exposure device according to any one of claims 1 to 7; and a part made of a material different from a material of the member for exposure device.

12. A pellicle frame comprising the member for exposure device according to any one of claims 1 to 7.

13. A composite pellicle frame comprising: the pellicle frame according to claim 12, and a part made of a material different from a material of the pellicle frame.
